(19) Europäisches Patentamt / European Patent Office / Office européen des brevets

(11) **EP 3 933 423 B1**

(12) # FASCICULE DE BREVET EUROPEEN

(45) Date de publication et mention de la délivrance du brevet:
**01.01.2025 Bulletin 2025/01**

(21) Numéro de dépôt: **21181069.2**

(22) Date de dépôt: **23.06.2021**

(51) Classification Internationale des Brevets (IPC):
**G01R 31/389** (2019.01)   **G01R 31/385** (2019.01)
**B07C 5/00** (2006.01)   **H01M 10/00** (2006.01)

(52) Classification Coopérative des Brevets (CPC):
**G01R 31/389; G01R 31/3865; H01M 10/4285;**
H01M 10/052; H01M 10/0562; Y02E 60/10;
Y02P 70/50

(54) **METHODE DE TEST(S) D'UN OU D'UNE PLURALITE DE DISPOSITIFS MICROBATTERIES ET SYSTEME METTANT EN OEUVRE LA METHODE DE TEST(S)**

METHODE ZUM TESTEN EINER ODER MEHRERER MIKROBATTERIEVORRICHTUNGEN UND SYSTEM ZUR DURCHFÜHRUNG DIESER TESTMETHODE

METHOD FOR TESTING ONE OR A PLURALITY OF MICROBATTERY DEVICES AND SYSTEM IMPLEMENTING THE TESTING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.07.2020 FR 2006930**

(43) Date de publication de la demande:
**05.01.2022 Bulletin 2022/01**

(73) Titulaire: **Commissariat à l'Energie Atomique et aux Energies Alternatives**
**75015 Paris (FR)**

(72) Inventeurs:
- **TOFFOLI, Alain**
  **38054 GRENOBLE Cedex 09 (FR)**
- **OUKASSI, Sami**
  **38054 GRENOBLE Cedex 09 (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**CN-A- 107 838 057     US-B2- 9 209 496**

- **XIAOYU LI ET AL: "A comparative study of sorting methods for Lithium-ion batteries", 2014 IEEE CONFERENCE AND EXPO TRANSPORTATION ELECTRIFICATION ASIA-PACIFIC (ITEC ASIA-PACIFIC), IEEE, 31 August 2014 (2014-08-31), pages 1 - 6, XP032671721, DOI: 10.1109/ITEC-AP.2014.6940724**
- **COLLINS JOHN ET AL: "Fundamentals, impedance, and performance of solid-state Li-metal microbatteries", JOURNAL OF VACUUM SCIENCE AND TECHNOLOGY: PART A, AVS /AIP, MELVILLE, NY., US, vol. 38, no. 3, 27 April 2020 (2020-04-27), XP012247065, ISSN: 0734-2101, [retrieved on 20200427], DOI: 10.1116/6.0000097**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 933 423 B1

## Description

Le domaine de l'invention est celui du test électrique des dispositifs électroniques ou technologiques réalisés en technique microélectronique: circuits intégrés, capteurs, dispositifs élémentaires (résistance, diode, capacité ...).

Plus spécifiquement, il s'agit d'une méthode de test électrique dédié à une certaine catégorie de composants de micro-stockage d'énergie, communément appelés microbatteries.

Une microbatterie est réalisée par un dépôt successif sur un substrat de (i) premier collecteur de courant, (ii) première électrode, (iii) électrolyte, (iv) deuxième électrode, et (v) deuxième collecteur de courant. Une encapsulation par le biais de dépôt de couches supplémentaires, ou par report de capot est nécessaire pour protéger le dispositif de la réactivité chimique avec l'oxygène et la vapeur d'eau.

De manière générale, les microbatteries peuvent être classées en trois catégories en fonction du type d'électrode négative (ou anode), souvent déposée au-dessus de l'électrolyte :

- anode en matériau de stockage des ions $Li^+$ : il s'agit souvent d'oxydes de métaux de transition (Vox, TiOx, NiOx, etc..) ou de matériaux cristallogènes (Si, Ge, C ou mélanges) ;
- anode en lithium métallique : une couche de lithium est déposée sous forme métallique au-dessus du collecteur ;
- anode en métal inerte vis-à-vis du lithium : cette configuration est souvent appelée *"Li-free"* en référence à l'article J. Electrochem. Soc.-2000-Neudecker-517-23*.*

Dans ce cas une anode en lithium métallique est formée au cours de la première charge de la batterie par électro-dépôt d'ions Li+ (en provenance de la cathode) entre l'électrolyte et le deuxième collecteur de courant.

La dernière configuration est la plus avantageuse dans le cas d'une intégration de microbatteries sur substrat silicium et d'utilisation de techniques de micro-fabrication : elle offre la présence de lithium-métal (l'anode la plus performante de par la densité d'énergie, du potentiel ainsi que de la cyclabilité) sans les inconvénients associés à sa présence en cours de procédé (sensibilité à l'air, incompatibilité avec les solutions de gravure et de photolithographie).

De manière générale, le protocole de tri et de tests électriques le plus utilisé et le plus fiable consiste à (i) tester la microbatterie sur plusieurs cycles de charge et de décharge complets (passer de totalement chargé à totalement déchargé) et (ii) comparer les valeurs de capacité, les profils de tension et la résistance interne à des valeurs de référence.

Cette approche présente néanmoins plusieurs limitations : dans le contexte des microbatteries, et plus particulièrement des microbatteries *"Li-free"*, le cyclage engendre des variations structurales au niveau de l'empilement actif, en l'occurrence la formation de lithium métallique la rendant très sensible à l'air et complexe à poursuivre en procédé technologique de fabrication.

Dans le cas de batteries de plus grande taille, l'application de cette méthode demeure très rare dans la mesure où elle nécessite de longues périodes de test, ce qui représente un coût important.

Le tri peut se baser sur un ou plusieurs paramètres de la microbatterie sans avoir à les cycler. Parmi les paramètres électriques les plus utilisés on peut citer :

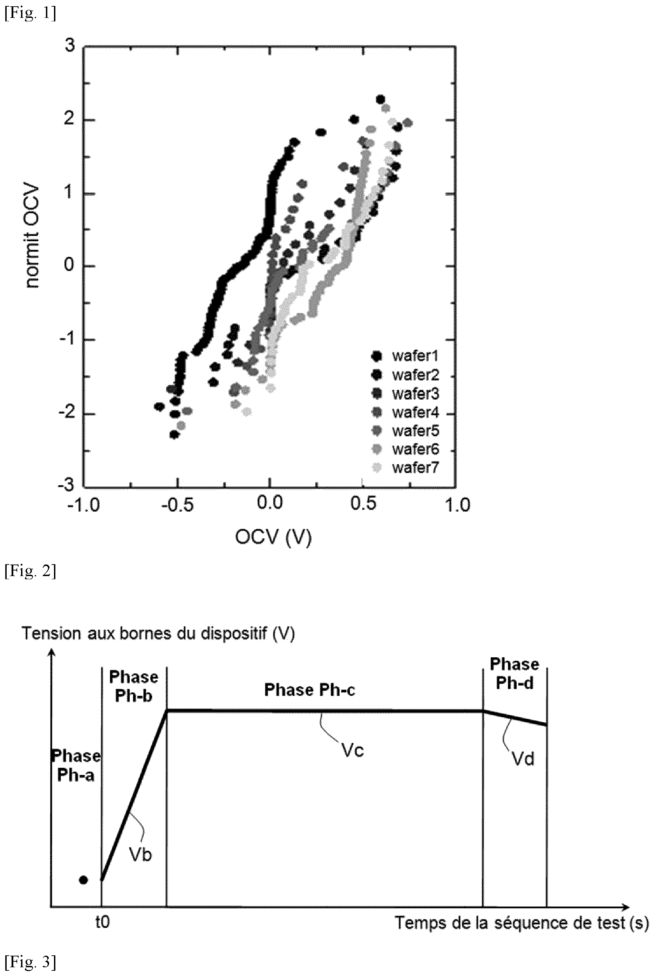

- la tension à circuit ouvert ou OCV (pour "**O**pen **C**ircuit **V**oltage"). Cette tension correspond à celle mesurée au niveau de la microbatterie dès la sortie de fabrication, et avant toute sollicitation électrique. Généralement elle donne une idée sur l'état de charge de la microbatterie. Ceci est vérifié par exemple dans le cas des microbatteries avec une anode en lithium métallique ou en anode de stockage. Dans le cas des microbatteries *"Li-free"*, il a été expérimentalement observé que l'OCV présentait une variabilité importante au sein d'une plaque et de plaque à plaque, et qu'aucune corrélation n'était possible entre OCV et état de charge comme montré sur la figure 1 qui illustre les variations de l'OCV pour un composant de type microbatterie réalisé sur un lot de 7 wafers. La variabilité est importante à la fois au sein d'une plaque et de plaque à plaque.
- La variabilité est liée au fait que l'anode en lithium n'est pas encore formée à ce stade, et la mesure OCV donne une information sur l'état des interfaces électrolyte/électrodes uniquement, sans lien avec l'état de charge ou le futur comportement électrique. En conséquence, ce paramètre n'est pas pertinent pour établir un tri de toutes les configurations de microbatteries.
- la résistance interne : elle correspond à l'ensemble des contributions résistives ayant lieu au sein de la structure de la microbatterie, il s'agit de la somme de la résistance de l'électrolyte, des transferts de charge au niveau des électrodes et des interfaces. Ce paramètre n'est pas pertinent pour un tri dans le cas des microbatteries *"Li-free"* pour la même raison que celle évoquée précédemment, l'anode en lithium métallique n'étant pas formée.

L'enjeu du tri dans ce cas précis est de pouvoir disposer de paramètres électriques pouvant servir à classer les microbatteries y compris celles en *"Li-free"* sans qu'on soit obligé de procéder au cyclage, au risque de ne pouvoir faire le tri qu'après la fin du procédé de fabrication. En effet trier sur la base de cyclage nécessite que la microbatterie soit encapsulée, soit au niveau de la plaque, soit après découpe et mise en boitier et ceci afin d'éviter les changements structuraux et la sensibilité à l'air liée à la présence de lithium métallique. Un tri intermédiaire pour réduire les coûts de fabrication et identifier les modes de défaillance n'est pas possible, et c'est ce qu'on cherche à avoir dans ce cas précis.

Le document US9209496 propose une méthode de tri consistant à mesurer la tension à circuit ouvert ou OCV (pour Open Circuit Voltage) d'une batterie, de la décharger pendant une certaine période et de comparer le potentiel de fin de décharge à celui de l'OCV. Il est clair que dans le cas des microbatteries *"Li-free"*, cette méthode de tri n'est pas adaptée dans la mesure ou (i) l'OCV n'apporte pas d'indications concernant l'état de la batterie, et (ii) la décharge des batteries *"Li-free"* ne permet pas de modifier leur potentiel de façon stable dans la mesure où la microbatterie est totalement déchargée au moment du test.

Le document US6526361 propose une méthode de tri consistant à appliquer plusieurs pulses successifs (soit une application de pulses de courant, soit de pulses de tension) avec une période de relaxation entre chaque pulse à des batteries, à mesurer la réponse en tension associée et à effectuer un tri en fonction de cette réponse. Cette approche n'est pas applicable à des microbatteries de type *"Li-free"* étant donné qu'elle nécessite un état initial stable en tension.

Le document « A comparative study of sorting methods for Lithium-ion batteries » de Xiaoyu Li et Al, XP032671721 et le document « Fundamentals, impédance, and performance of solid-state Ll-metal microbatteries » de Collins John et Al, XP012247065 divulguent des méthodes de tri des batteries de type Lithium-ion.

Dans ce contexte et pour pallier les problèmes précités, la présente invention a pour objet une méthode de test particulièrement bien adaptée aux microbatteries de type *"Li-Free"*, pour lesquelles les méthodes de l'art connu ne sont pas compatibles. Cette méthode permet d'effectuer des tests non dégradants et rapides, de plus cette méthode peut s'appliquer à un ou une pluralité de dispositifs testés en parallèle.

Plus précisément, la présente invention a pour objet une méthode de test d'au moins un dispositif de micro-stockage d'énergie comprenant une anode en lithium métallique formée par électro-dépôt d'ions $Li^+$ sur un métal inerte vis-à-vis d'ions lithium, un électrolyte et une cathode, ladite méthode comprenant une séquence d'étapes de test en cours de fabrication de ladite anode, ladite séquence comportant :

- une étape de mesure **Ph-a** de la tension initiale OCV dudit dispositif en circuit ouvert permettant d'obtenir à un instant **t0**, la valeur de la tension initiale dudit dispositif de micro-stockage d'énergie ;
- si ladite tension initiale est non nulle, une étape de première charge **Ph-b** comprenant :

  o l'application d'un courant **Ib** pendant un temps **tb** permettant de charger une première partie dudit dispositif durant un temps minimal de charge pour former une première épaisseur de couche de lithium en anode ;

  o la mesure de la tension **Vb** aux bornes dudit dispositif ;

  la détermination de la résistance interne **Rb** étant relative à l'état de charge considéré dudit dispositif ;

- si la tension Vb est située dans un intervalle $Vb_{min}$-$Vb_{max}$ défini en fonction de l'architecture du composant et si la résistance **Rb** est située dans un intervalle $Rb_{min}$-$Rb_{max}$ défini en fonction de l'architecture du composant, une étape de stabilisation **Ph-c** comprenant :

  o la continuation de l'application d'au moins un courant **Ic** pendant un temps **tc** permettant de charger une deuxième partie dudit dispositif durant un deuxième temps de charge **tc** pour former une deuxième épaisseur de couche de lithium en anode ;

  o la mesure de la tension **Vc** aux bornes dudit dispositif ;

- si la tension **Vc** est située dans un intervalle $Vc_{min}$-$Vc_{max}$ défini en fonction de l'architecture du composant, une étape de rétention **Ph-d** comprenant :

  o l'application d'un courant nul durant un temps **td** ;
  o la mesure de la tension **V** aux bornes du dispositif au cours du temps ;
  o la détermination du paramètre **Vd** avec **Vd** = $\Delta V/\Delta t$ ;
  o si **Vd** est situé dans un intervalle $Vd_{min}$-$Vd_{max}$ défini en fonction de l'architecture du composant, ledit dispositif est testé valide.

Selon des variantes de l'invention :

- l'étape de première charge comporte une série de mesures de tensions **Vbi** pendant des durées $\Delta tbi$ espacées de temps **Tbi** permettant de déterminer la courbe **Vbi** en fonction du temps et permettant de déterminer la valeur de la tension **Vb** pouvant être définie comme la valeur maximale des tensions **Vbi** ou la moyenne des tensions **Vbi** ;

- la résistance **Rb** peut être déterminée après chaque temps **tbi** par le rapport **Vbi/Ic** de la courbe **Vbi** en fonction du temps **t**.

Selon des variantes de l'invention, les durées $\Delta tbi$ sont de l'ordre de 10 secondes, les temps **Tbi** étant de l'ordre de 0,1 seconde.

Selon des variantes de l'invention, la première épaisseur est de l'ordre de quelques nanomètres et de préférence de 1 à 2 nanomètres.

Selon des variantes de l'invention :

- l'étape de stabilisation comporte une série de mesures de tension **Vci** pendant des durées Δ**tci** espacées de temps **Tci** permettant de déterminer la valeur de la tension **Vc** définie comme la moyenne des tensions **Vci.**

Selon des variantes de l'invention, les durées Δ**tci** sont de l'ordre de 50 secondes, les temps **Tci** étant de l'ordre de 1 seconde.

Selon des variantes de l'invention, la seconde épaisseur est inférieure à 10 nanomètres et de préférence égale à 5 nanomètres.

Selon des variantes de l'invention :

- l'étape de rétention comporte une série de mesures de tension **Vdi** pendant des durées Δ**tdi** espacés de temps **Tdi** permettant de déterminer la courbe **Vdi** en fonction du temps ;

- le paramètre **Vd** est déterminé par la pente de la courbe **Vdi** en fonction du temps t.

Selon des variantes de l'invention, les durées Δ**tdi** sont de l'ordre de 10 secondes, les temps **Tdi** étant de l'ordre de 1 seconde.

L'invention a aussi pour objet un système de test d'au moins un dispositif de micro-stockage d'énergie, mettant en oeuvre la méthode de test de d'invention, comprenant :

- un générateur de courant connecté audit dispositif ;

- un voltmètre connecté audit dispositif ;

- un contrôleur relié audit générateur de courant et audit voltmètre.

Selon des variantes de l'invention, le générateur de courant est programmable et le voltmètre est programmable.

Selon des variantes de l'invention, le contrôleur comprend un chronomètre, une mémoire et un processeur.

L'invention a également pour objet un ensemble d'une pluralité de systèmes de test de dispositif de micro-stockage d'énergie, mettant en oeuvre la méthode selon l'invention, chaque système comprenant :

- un générateur de courant pouvant être programmable connecté audit dispositif ;

- un voltmètre pouvant être programmable connecté audit dispositif,

- chaque générateur de courant et chaque voltmètre étant reliés à un contrôleur.

L'invention a encore pour objet un ensemble d'une pluralité de systèmes de test de dispositif de micro-stockage d'énergie, mettant en oeuvre la méthode de test selon l'invention, chaque système comprenant :

- un générateur de courant pouvant être programmable connecté audit dispositif ;

- un voltmètre pouvant être programmable connecté audit dispositif,

- chaque générateur de courant et chaque voltmètre étant reliés à un même contrôleur central.

Selon des variantes de l'invention, le système de test est tel que chaque contrôleur ou le contrôleur central comprend un chronomètre, une mémoire et un processeur.

Le système de test de l'invention peut comprendre un contrôleur central comportant une mémoire, chaque contrôleur gérant les phases de test pour chaque système de test, enregistrant les résultats de mesure de tension dans sa mémoire, le contrôleur central récupérant lesdits résultats de mesure pour les enregistrer dans sa mémoire.

L'invention sera mieux comprise et d'autres avantages apparaîtront à la lecture de la description qui va suivre donnée à titre non limitatif et grâce aux figures annexées parmi lesquelles :

[Fig 1] illustre les variations de l'OCV pour un composant de type microbatterie réalisé sur un lot de 7 wafers, et plus précisément un diagramme de Henry, dans lequel l'ordonnée est la fonction Normit de x, décrite en détail dans le document accessible via le lien : http://www.modulad.fr/numero-35/Excelense-gre nier-35/DiagrammedeHenry.pdf ;

[Fig 2] illustre l'évolution de la tension au bornes d'un dispositif de microbatterie en fonction du temps au cours de l'ensemble des étapes de la méthode de test selon l'invention ;

[Fig 3] illustre un organigramme comprenant l'ensemble des phases de test successives dans la méthode de test selon l'invention ;

[Fig 4] illustre un exemple de système de test d'une pluralité de dispositifs de micro-stockage d'énergie selon l'invention, chaque dispositif étant relié à un contrôleur ;

[Fig 5] illustre un exemple de système de test d'une pluralité de dispositifs de micro-stockage d'énergie selon l'invention, chaque dispositif étant relié à un même contrôleur central.

De manière générale, la méthode de test proposée dans la présente invention a pour objectif de palier aux différents inconvénients précités et ce, en utilisant une technique de tests non dégradante et rapide. Avantageusement, cette technique peut s'appliquer à un ou une pluralité de dispositifs testés en parallèle.

La méthode de test de l'invention utilise la séquence de test décrite ci-après, enchainant les différentes étapes après validation d'un critère dans l'étape précédente, permettant ainsi de conclure au plus tôt sur un dispositif défaillant.

Le dispositif de micro-stockage d'énergie est dénommé ci-après microbatterie.

Il est décrit dans le cadre d'un exemple de microbatterie à base de lithium comprenant une anode métallique pouvant être en métal par exemple en titane et comprend un électrolyte solide pouvant par exemple être en LiPON (terme anglais : Lithium Phosphorus Oxynitride, soit l'oxynitrure de Li-phosphore) et une cathode pouvant par exemple être en $LiCoO_2$.

Cette technique est avantageuse car elle applique pour chaque dispositif testé quatre phases qui sont déclenchées l'une après l'autre lorsqu'un critère de validation est assuré. Ces quatre phases détaillées ci-après sont dénommées, phase de mesure de la tension initiale OCV, phase de charge, phase de stabilisation et phase de rétention. La figure 2 illustre l'enchaînement de ces phases en montrant l'évolution de la tension aux bornes du dispositif testé en fonction du temps dans un exemple de méthode décrit plus en détails ci-après.

Cette séquence de phases de test est décrite en détails dans la suite de la description et est illustrée également par l'organigramme illustré en figure 3.

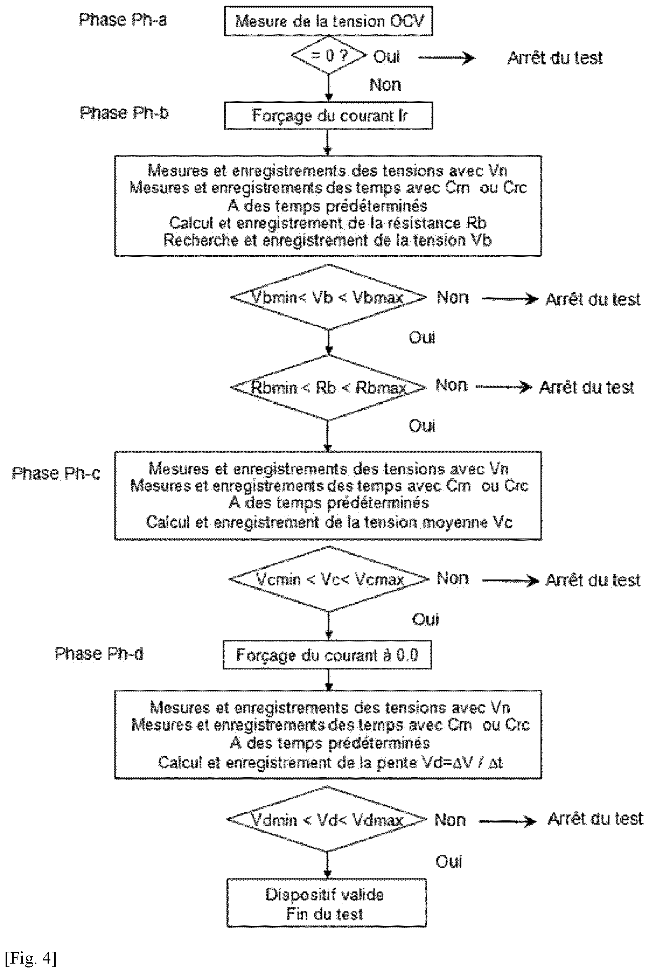

Le système de test est réalisé sur un dispositif ou la pluralité de systèmes de test peuvent être réalisés en parallèle sur un ensemble de dispositifs. Les moyens utilisés pour mettre en oeuvre la méthode de test de l'invention peuvent être, selon une première variante de l'invention, les moyens suivants et ce pour le test de chaque dispositif **Dn**, seul un de ces dispositifs **Dn** étant représenté en figure 4. Ces moyens comprennent un générateur de courant programmable **An**, un voltmètre programmable **Vn** et un contrôleur **Cn**. Le dispositif **An** présente une connexion d'anode **Dn-Anode** et une connexion de cathode **Dn-cathode**, le générateur **An** : une connexion positive **An-H** et une connexion négative **An-L,** le voltmètre : une connexion positive **Vn-H** et une connexion négative **Vn-L.**

La méthode de test consiste à effectuer le test de dispositif microbatterie en reliant les connexions **An-H** du générateur de courant, **Vn-H** du voltmètre et **Dn-Anode** du dispositif microbatterie ensemble, les connexions **An-L** du générateur de courant, **Vn-L** du voltmètre et **Dn-Cathode** du même dispositif microbatterie ensemble. Ce système de base peut être répété une pluralité de fois pour tester une pluralité de dispositifs.

Chaque système de base peut être piloté par un contrôleur **Cn** comportant un processeur **Pn**, un chronomètre **Crn** et une mémoire **Mn**, ce contrôleur est relié à chaque voltmètre **Vn** et chaque générateur de courant **An** et devient partie intégrante du ce système comme le montre également la figure 4 ; dans ce cas tous les contrôleurs **Cn** de la pluralité des systèmes de tests sont reliés eux-mêmes à un contrôleur central **Cc** pour piloter l'ensemble des systèmes de tests. Cette configuration est avantageuse dans la mesure ou l'algorithme utilisé présente une meilleure flexibilité et une mise en oeuvre plus simple.

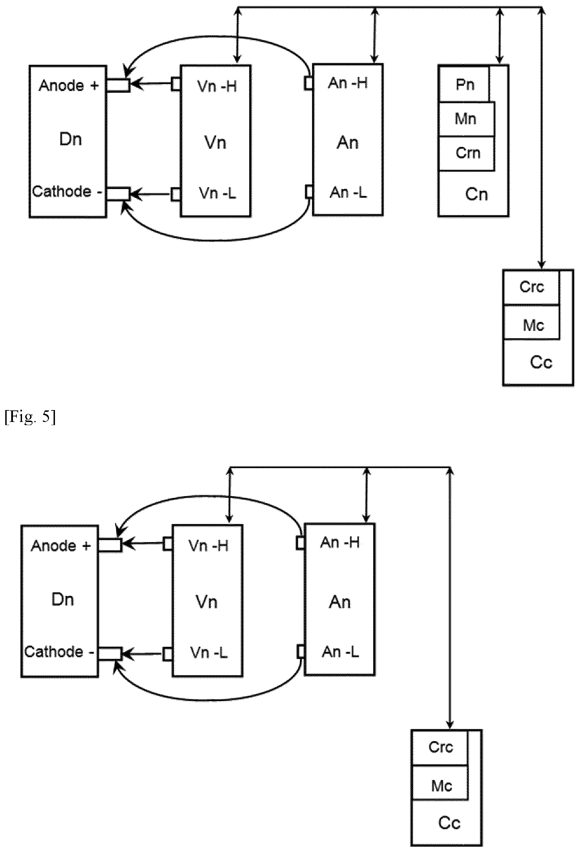

Selon une autre variante de l'invention, la pluralité des systèmes peut être pilotée par un contrôleur central **Cc** comportant un chronomètre **Crc** et une mémoire **Mc** relié à tous les voltmètres **Vn** et à tous les générateurs de courant **An** comme le montre la figure 5.

Ainsi les moyens de contrôle peuvent être assurés soit par un contrôleur central, soit par un ensemble de contrôleurs individuels. Dans tous les cas, le contrôleur utilisé possède dans sa mémoire **Mn** ou **Mc**, les temps caractéristiques auxquels sont faites les mesures de tensions par les voltmètres **Vn** et les mesures de temps par les chronomètres **Crn** ou le chronomètre **Crc.** Le contrôleur utilisé enregistre ces mesures de temps et de tensions dans sa mémoire **Mn** ou **Mc.**

Dans le cas où il n'existe que le contrôleur central **Cc,** celui-ci gère les séquences de tests pour la pluralité des systèmes de tests et enregistre les résultats des mesures dans sa mémoire **Mc** ; dans le cas où il y a un contrôleur **Cn** associé à chaque système de test, chaque contrôleur **Cn** gère la séquence de test pour chaque système de test, il enregistre les résultats des mesures dans sa mémoire **Mn**, puis le contrôleur central récupère tous les résultats des mesures et les enregistre dans sa mémoire **Mc.**

La méthode de test selon l'invention débute par une première phase **Ph-a** comportant la mesure de la tension initiale **OCV** de chaque dispositif grâce au voltmètre **Vn** connecté à chaque dispositif, chacune de ces mesures est enregistrée dans la mémoire **Mn** de chaque contrôleur **Cn** de chaque système, ou dans la mémoire **Mc** du contrôle Central **Cc.** Cette première phase permet par exemple d'obtenir le paramètre **OCV** (Open Circuit Voltage) de chaque dispositif, à partir de la mesure de cette tension à l'instant **t0.** Seule la mesure d'une valeur égale à zéro est utile dans le cas des microbatteries "Li-free", car elle signifie une défaillance en mode court-circuit et permet d'arrêter les tests pour les composants concernés. La Phase **Ph-a** reprise sur l'organigramme de la figure 3 illustre cette première phase qui peut être conclusive et stopper le test sur un dispositif défaillant.

Ensuite, pendant une seconde phase appelée phase de charge **Ph-b** chaque générateur de courant **An** connecté à chaque dispositif **Dn** applique un courant **Ib** à chaque dispositif à partir d'un temps **t0.** Ce courant permet de charger une partie minime du dispositif, ce qui a pour effet de ne pas endommager le dispositif. Plus spécifiquement, cette opération consiste à initier la migration des ions Li+, et former une épaisseur nanométrique continue (par exemple de 1 à 2 nm) de lithium en anode, et par conséquent le passage d'une configuration "Li-free" à Li métallique, sans impact structural sur le composant, ce qui permet d'assurer à la fois une pertinence du tri a posteriori ainsi que la possibilité de faire ce tri à tout moment du procédé de fabrication.

Cette deuxième phase permet par exemple d'obtenir le paramètre **Vb** en extrayant la tension max obtenue à partir des mesures enregistrées pendant cette phase. Les composants sont considérés conformes si la tension **Vb** est située dans un intervalle $V_{bmin}$-$V_{bmax}$ défini en fonction de l'architecture du composant. L'intervalle $V_{bmin}$-$V_{bmax}$ est essentiellement défini par le couple redox en jeu, plus spécifiquement par le potentiel de la cathode (ou électrode positive) vis-à-vis d'une électrode en lithium métallique. Par exemple dans le cas d'une cathode en LiCoO2 cet intervalle correspondra à 3.85-3.89V, alors que dans le cas d'une cathode en Li4Ti5O12, cet intervalle correspondra à 1.4-1.6V. La phase **Ph-b** reprise sur l'organigramme de la figure 3 illustre cette seconde phase qui peut être conclusive et permettre de poursuivre ou de stopper le test si le dispositif ne répondant pas aux valeurs attendues est considéré non conforme.

Ensuite pendant une troisième phase appelée phase de stabilisation **Ph-c,** le processus de la phase de charge **Ph-b** se poursuit avec des temps prédéterminés différents qui peuvent être par exemple des temps espacés de 1 seconde pendant 50 secondes, chaque générateur de courant **An** connecté à chaque dispositif **Dn** continue d'appliquer un courant **Ic** (qui peut être égal à **Ib**) à chaque dispositif **Dn.** Cette étape a pour objectif d'ajuster l'épaisseur de la couche de Li nanométrique par rapport aux besoins des tests électriques. Plusieurs épaisseurs peuvent être intéressantes. L'épaisseur maximale suffisante peut typiquement être inférieure à 10 nm, et de préférence inférieure à 5 nm. Il est à noter que l'épaisseur totale de lithium métallique qui sera utilisée dans le cas d'un cyclage complet correspond à 5000 nm, la proportion utilisée pour le test est d'à peu près 1/1000eme.

Ceci constitue un grand intérêt de la présente méthode qui permet d'élaborer des tests conclusifs dès le début de la formation de l'électrode lithium métal et ne nécessite pas d'avoir à achever le processus de fabrication pour pouvoir tester le dispositif de microbatterie.

Cette troisième phase permet par exemple d'obtenir le paramètre Vc en extrayant la moyenne des valeurs des tensions obtenues à partir des mesures enregistrées pendant cette phase. Les composants sont considérés conformes si le paramètre Vc est situé dans un intervalle $V_{cmin}$-$V_{cmax}$ défini en fonction de l'architecture du composant. La détermination de $V_{cmin}$-$V_{cmax}$ est essentiellement lié à la variation théorique du potentiel de la microbatterie après l'injection d'une quantité de charge correspondant à **Ic*temps.** Cette quantité est très faible (inférieure à 0.1% de la quantité de charge totale que peut stocker la microbatterie) et dans le cas d'une microbatterie fonctionnelle, les valeurs $V_{cmin}$-$V_{cmax}$ sont sensiblement similaires (+/-10%) aux valeurs $V_{bmin}$-$V_{bmax}$. Dans le cas d'une microbatterie non fonctionnelle, l'écart entre les deux plages de potentiel sera plus important. La phase **Ph-c** reprise sur l'organigramme de la figure 3 illustre cette troisième phase qui peut être conclusive et permet de poursuivre ou de stopper le test si le dispositif ne répondant pas aux valeurs attendues est considéré non conforme.

D'autres paramètres peuvent être envisagés pendant cette phase : par exemple pente, ou delta V.... La valeur de la pente ($V_{cmin}$-$V_{cmax}$)/Ic permet de donner une estimation de la résistance interne de la microbatterie à cet état de charge précis, de la même manière l'écart entre $V_{cmin}$ et $V_{cmax}$ ou le ratio $V_{cmin}$/$V_{cmax}$ peut renseigner sur la cinétique de charge de la microbatterie.

Ensuite pendant une quatrième phase appelée phase de rétention **Ph-d** chaque générateur de courant applique un courant nul, et le processus de la phase **Ph-b** et de la phase **Phc** se poursuit avec des temps prédéterminés espacés par exemple de 1 seconde pendant 10 secondes. Cette quatrième phase permet par exemple d'obtenir le paramètre **Vd** en extrayant la pente (dérivée) de la courbe tension versus temps obtenue à partir des mesures enregistrées pendant cette phase. Les composants sont considérés conformes, si le paramètre **Vd** est situé dans un intervalle $V_{dmin}$-$V_{dmax}$ défini en fonction de l'architecture du composant. La phase **Ph-d** figurant sur l'organigramme de la figure 3 illustre cette quatrième phase qui permet de conclure que le dispositif testé est conforme. Cette phase permet d'évaluer la cinétique et l'amplitude de relaxation de la microbatterie après la phase de charge précédente. Idéalement, la relaxation se limite à une baisse du potentiel équivalente **à Ic*Rint** (résistance interne), cette valeur étant très faible vu le faible courant le utilisé.

Idéalement :

$$Vb=Vc=Vd$$

L'ensemble des paramètres précédemment obtenus peut également être traité selon des lois statistiques pour caractériser la pluralité d'éléments.

La méthode de test selon l'invention est avantageuse car elle permet d'obtenir sur des dispositifs en cours de fabrication (directement sur plaquette), un ensemble de paramètres caractérisant une pluralité de dispositifs en un temps, si l'on prend les exemples de valeurs prédéterminées données dans les phases **Ph-a** à **Ph-d,** de 1 minute et 10 secondes, et ce sans être destructive pour les dispositifs, permettant ensuite de finir les étapes de fabrication.

**Revendications**

1. Méthode de test d'au moins un dispositif de microstockage d'énergie comprenant une anode en lithium métallique formée par électro-dépôt d'ions Li+ sur un métal inerte vis-à-vis d'ions lithium, un électrolyte et une cathode, **caractérisé en ce que** ladite méthode comprend une séquence d'étapes de test en cours de fabrication de ladite anode, ladite séquence comportant :

- une étape de mesure (**Ph-a**) de la tension initiale (**OCV**) dudit dispositif en circuit ouvert permettant d'obtenir à un instant **t0**, la valeur de la tension initiale dudit dispositif de micro-stockage d'énergie ;
- si ladite tension initiale est non nulle, une étape de première charge (**Ph-b**) comprenant :

o l'application d'un courant **Ib** pendant un temps **tb** permettant de charger une première partie dudit dispositif durant un temps minimal de charge pour former une première épaisseur de couche de lithium en anode ;
o la mesure de la tension **Vb** aux bornes dudit dispositif ;

la détermination de la résistance interne **Rb** ;
- si la tension **Vb** est située dans un intervalle **Vb$_{min}$-Vb$_{max}$** défini en fonction de l'architecture du composant et si la résistance **Rb** est située dans un intervalle **Rb$_{min}$-Rb$_{max}$** défini en fonction de l'architecture du composant, une étape de stabilisation (**Ph-c**) comprenant :

o la continuation de l'application d'au moins un courant **Ic** pendant un temps **tc** permettant de charger une deuxième partie dudit dispositif durant un deuxième temps de charge **tc** pour former une deuxième épaisseur de couche de lithium en anode ;
o la mesure de la tension **Vc** aux bornes dudit dispositif ;

- si la tension **Vc** est située dans un intervalle **Vc$_{min}$-Vc$_{max}$** défini en fonction de l'architecture du composant, une étape de rétention (**Ph-d**) comprenant :

o l'application d'un courant nul durant un temps **td** ;
o la mesure de la tension **V aux** bornes du dispositif au cours du temps ;
o la détermination du paramètre **Vd** avec **Vd = ΔV/Δt** ;
o si **Vd** est situé dans un intervalle **Vd$_{min}$-Vd$_{max}$** défini en fonction de l'architecture du composant, ledit dispositif est testé valide.

2. Méthode de test selon la revendication 1, dans laquelle :

- l'étape de première charge comporte une série de mesures de tensions **Vbi** pendant des durées Δ**tbi** espacées de temps **Tbi** permettant de déterminer la courbe **Vbi** en fonction du temps et permettant de déterminer la valeur de la tension **Vb** pouvant être définie comme la valeur maximale des tensions **Vbi** ou la moyenne des tensions **Vbi;**
- la résistance **Rb** peut être déterminée après chaque temps **tbi** par le rapport **Vbi/Ic** de la courbe **Vbi** en fonction du temps **t.**

3. Méthode de test selon la revendication 2, dans laquelle les durées Δ**tbi** sont de l'ordre de 10 secondes, les temps **Tbi** étant de l'ordre de 0,1 seconde.

4. Méthode de test selon l'une des revendications 1 ou 2, dans laquelle la première épaisseur est de l'ordre de quelques nanomètres et de préférence de 1 à 2 nanomètres.

5. Méthode de test selon l'une des revendications 2 à 4, dans laquelle :

- l'étape de stabilisation comporte une série de mesures de tension **Vci** pendant des durées Δ**tci** espacées de temps **Tci** permettant de déterminer la valeur de la tension **Vc** définie comme la moyenne des tensions **Vci.**

6. Méthode de test selon la revendication 5, dans laquelle les durées Δ**tci** sont de l'ordre de 50 secondes, les temps **Tci** étant de l'ordre de 1 seconde.

7. Méthode de test selon l'une des revendications 1 à 6, dans laquelle la seconde épaisseur est inférieure à 10 nanomètres et de préférence égale à 5 nanomètres.

8. Méthode de test selon l'une des revendications 1 à 7, dans laquelle :

- l'étape de rétention comporte une série de mesures de tension **Vdi** pendant des durées Δ**tdi** espacés de temps **Tdi** permettant de déterminer la courbe Vdi en fonction du temps ;
- le paramètre **Vd** est déterminé par la pente de la courbe **Vdi** en fonction du temps t.

9. Méthode de test selon la revendication 8, dans laquelle les durées Δ**tdi** sont de l'ordre de 10 secondes, les temps **Tdi** étant de l'ordre de 1 seconde.

10. Système de test d'au moins un dispositif de micro-stockage d'énergie, mettant en oeuvre une méthode de test d'au moins un dispositif de micro-stockage d'énergie comprenant une anode en lithium métallique formée par électro-dépôt d'ions Li$^+$ sur un métal inerte vis-à-vis d'ions lithium, un électrolyte et une cathode, selon l'une des revendications 1 à 9, ladite méthode de test comprenant une séquence d'étapes de test en cours de fabrication de ladite anode, ladite séquence comportant :

- une étape de mesure (Ph-a) de la tension initiale (OCV) dudit dispositif en circuit ouvert permettant d'obtenir à un instant t0, la valeur de la tension initiale dudit dispositif de micro-stockage d'énergie ;
- si ladite tension initiale est non nulle, une étape de première charge (Ph-b) comprenant :

   o l'application d'un courant **Ib** pendant un temps **tb** permettant de charger une première partie dudit dispositif durant un temps minimal de charge pour former une première épaisseur de couche de lithium en anode ;
   o la mesure de la tension **Vb** aux bornes dudit dispositif ;

la détermination de la résistance interne **Rb** ;
- si la tension **Vb** est située dans un intervalle **Vb$_{min}$-Vb$_{max}$** défini en fonction de l'architecture du composant et si la résistance **Rb** est située dans un intervalle **Rb$_{min}$-Rb$_{max}$** défini en fonction de l'architecture du composant, une étape de stabilisation (**Ph-c**) comprenant :

   o la continuation de l'application d'au moins un courant **Ic** pendant un temps tc permettant de charger une deuxième partie dudit dispositif durant un deuxième temps de charge **tc** pour former une deuxième épaisseur de couche de lithium en anode ;
   o la mesure de la tension **Vc** aux bornes dudit dispositif ;

- si la tension **Vc** est située dans un intervalle **Vc$_{min}$-Vc$_{max}$** défini en fonction de l'architecture du composant, une étape de rétention (**Ph-d**) comprenant :

   o l'application d'un courant nul durant un temps **td** ;
   o la mesure de la tension **V aux** bornes du dispositif au cours du temps ;
   o la détermination du paramètre **Vd** avec **Vd = ΔV/Δt** ;
   ∘ **si Vd** est situé dans un intervalle **Vd$_{min}$-Vd$_{max}$** défini en fonction de l'architecture du composant, ledit dispositif est testé valide ;

ledit système de test comprenant :

- un générateur de courant configuré pour être connecté audit dispositif ;
- un voltmètre configuré pour être connecté audit dispositif ;

- un contrôleur relié audit générateur de courant et audit voltmètre.

11. Système de test selon la revendication 10, dans lequel le générateur de courant est programmable et le voltmètre est programmable.

12. Système de test selon l'une des revendications 10 ou 11, dans lequel le contrôleur comprend un chronomètre, une mémoire et un processeur.

13. Ensemble d'une pluralité de systèmes de test de dispositif de micro-stockage d'énergie (**Dn**), selon l'une des revendications 10 à 12,

   mettant en oeuvre la méthode selon l'une des revendications 1 à 9,
   chaque système comprenant :

   - un générateur de courant (**An**) pouvant être programmable et configuré pour être connecté audit dispositif (**Dn**) ;
   - un voltmètre (**Vn**) pouvant être programmable et configuré pour être connecté audit

   dispositif (**Dn**),

   - chaque générateur de courant (**An**) et chaque voltmètre (**Vn**) étant reliés à un contrôleur (**Cn**).

14. Système de test selon l'une des revendications 10 à 12, dans lequel chaque contrôleur ou un contrôleur central comprend un chronomètre, une mémoire et un processeur.

15. Système de test selon la revendication 12 et la revendication 14, comprenant un contrôleur central (**Cc**) comportant une mémoire (**Mc**), chaque contrôleur (**Cn**) gérant les phases de test pour chaque système de test, enregistrant les résultats de mesure de tension dans sa mémoire (**Mn**), le contrôleur central récupérant lesdits résultats de mesure pour les enregistrer dans sa mémoire (**Mc**).

**Patentansprüche**

1. Verfahren zum Testen mindestens einer Mikro-Energiespeichervorrichtung, umfassend eine Lithium-Metall-Anode, die durch Elektroabscheidung von Li$^+$-Ionen auf ein gegenüber Lithiumionen inertes Metall gebildet wird, einen Elektrolyten und eine Kathode, **dadurch gekennzeichnet, dass** das Verfahren eine Abfolge von Testschritten im Verlauf der Herstellung der Anode umfasst, wobei die Abfolge Folgendes aufweist:

- einen Schritt zum Messen (Ph-a) der Anfangsspannung (OCV) der Vorrichtung im Leerlaufmodus, wodurch zu einem Zeitpunkt t0 der Wert der Anfangsspannung der Mikro-Energiespeichervorrichtung erhalten werden kann;
- wenn die Anfangsspannung ungleich null ist, einen Schritt der ersten Aufladung (Ph-b), Folgendes umfassend:

> o Anlegen eines Stroms Ib während einer Zeit tb, wodurch ein erster Teil der Vorrichtung während einer minimalen Ladezeit geladen werden kann, um eine erste Lithiumschichtdicke an der Anode zu bilden;
> o Messen der Spannung Vb an den Anschlussklemmen der Vorrichtung;

Bestimmen des internen Widerstands Rb;
- wenn die Spannung Vb in einem in Abhängigkeit von der Architektur der Komponente definierten Intervall $Vb_{min}$-$Vb_{max}$ liegt und wenn der Widerstand Rb in einem in Abhängigkeit von der Architektur der Komponente definierten Intervall $Rb_{min}$-**$Rb_{max}$** liegt, einen Stabilisierungsschritt (Ph-c), Folgendes umfassend:

> o Fortführen des Anlegens mindestens eines Stroms Ic während einer Zeit tc, wodurch ein zweiter Teil der Vorrichtung während einer zweiten Ladezeit tc geladen werden kann, um eine zweite Lithiumschichtdicke an der Anode zu bilden;
> o Messen der Spannung Vc an den Anschlussklemmen der Vorrichtung;

- wenn die Spannung Vc in einem in Abhängigkeit von der Architektur der Komponente definierten Intervall $Vc_{min}$-$Vc_{max}$ liegt, einen Rückhalteschritt (Ph-d), Folgendes umfassend:

> o Anlegen eines Stroms von null während einer Zeit td;
> o Messen der Spannung V an den Anschlussklemmen im zeitlichen Verlauf;
> o Bestimmen des Parameters Vd mit Vd = $\Delta V/\Delta t$;
> o wenn Vd in einem in Abhängigkeit von der Architektur der Komponente definierten Intervall $Vd_{min}$-$Vd_{max}$ liegt, ist die Vorrichtung als freigegeben getestet.

2. Testverfahren nach Anspruch 1, wobei:

> - der Schritt des ersten Ladens eine Reihe von Spannungsmessungen Vbi während Zeitdauern $\Delta tbi$ aufweist, die durch Zeiten Tbi beabstandet sind, wodurch die Kurve Vbi in Abhängigkeit von der Zeit bestimmt werden kann und der Wert der Spannung Vb bestimmt werden kann, der als maximaler Wert der Spannungen Vbi oder als Durchschnitt der Spannungen Vbi definiert werden kann;
- der Widerstand Rb nach jeder Zeit tbi durch das Verhältnis Vbi/Ic der Kurve Vbi in Abhängigkeit von der Zeit t bestimmt werden kann.

3. Testverfahren nach Anspruch 2, wobei die Zeitdauern $\Delta tbi$ in der Größenordnung von 10 Sekunden liegen, wobei die Zeiten Tbi in der Größenordnung von 0,1 Sekunde liegen.

4. Testverfahren nach einem der Ansprüche 1 oder 2, wobei die erste Dicke in der Größenordnung von einigen Nanometern und vorzugsweise 1 bis 2 Nanometern liegt.

5. Testverfahren nach einem der Ansprüche 2 bis 4, wobei:

> - der Stabilisationsschritt eine Reihe von Messungen der Spannung Vci während Zeitdauern $\Delta tci$ aufweist, die durch Zeiten Tci beabstandet sind, wodurch der Wert der Spannung Vc, der als Durchschnitt der Spannungen Vci definiert ist, bestimmt werden kann.

6. Testverfahren nach Anspruch 5, wobei die Zeitdauern $\Delta tci$ in der Größenordnung von 50 Sekunden liegen, wobei die Zeiten Tci in der Größenordnung von 1 Sekunde liegen.

7. Testverfahren nach einem der Ansprüche 1 bis 6, wobei die zweite Dicke unter 10 Nanometern liegt und vorzugsweise 5 Nanometer beträgt.

8. Testverfahren nach einem der Ansprüche 1 bis 7, wobei:

> - der Rückhalteschritt eine Reihe von Messungen der Spannung Vdi während Zeitdauern $\Delta tdi$ aufweist, die durch Zeiten Tdi beabstandet sind, wodurch die Kurve Vbi in Abhängigkeit von der Zeit bestimmt werden kann;
> - der Parameter Vd durch den Steigungskoeffizienten der Kurve Vdi in Abhängigkeit von der Zeit t bestimmt wird.

9. Testverfahren nach Anspruch 8, wobei die Zeitdauern $\Delta tdi$ in der Größenordnung von 10 Sekunden liegen, wobei die Zeiten Tdi in der Größenordnung von 1 Sekunde liegen.

10. System zum Testen mindestens einer Mikro-Energiespeichervorrichtung, das ein Verfahren zum Testen mindestens einer Mikro-Energiespeichervorrichtung implementiert, umfassend eine Lithium-Metall-Anode, die durch Elektroabscheidung von Li⁺-Ionen auf ein gegenüber Lithiumionen inertes Metall gebildet wird, einen Elektrolyten und eine Kathode, nach einem der Ansprüche 1 bis 9, wobei das Testverfahren eine Abfolge von Testschritten im Verlauf der Herstellung der Anode umfasst, wobei die Abfolge Folgendes aufweist:

- einen Schritt zum Messen (Ph-a) der Anfangsspannung (OCV) der Vorrichtung im Leerlaumodus, wodurch zu einem Zeitpunkt t0 der Wert der Anfangsspannung der Mikro-Energiespeichervorrichtung erhalten werden kann;
- wenn die Anfangsspannung ungleich null ist, einen Schritt der ersten Aufladung (Ph-b), Folgendes umfassend:

   o Anlegen eines Stroms Ib während einer Zeit tb, wodurch ein erster Teil der Vorrichtung während einer minimalen Ladezeit geladen werden kann, um eine erste Lithiumschichtdicke an der Anode zu bilden;
   o Messen der Spannung Vb an den Anschlussklemmen der Vorrichtung;

Bestimmen des internen Widerstands Rb;
- wenn die Spannung Vb in einem in Abhängigkeit von der Architektur der Komponente definierten Intervall $Vb_{min}$-$Vb_{max}$ liegt und wenn der Widerstand Rb in einem in Abhängigkeit von der Architektur der Komponente definierten Intervall $Rb_{min}$-**$Rb_{max}$** liegt, einen Stabilisierungsschritt (Ph-c), Folgendes umfassend:

   o Fortführen des Anlegens mindestens eines Stroms Ic während einer Zeit tc, wodurch ein zweiter Teil der Vorrichtung während einer zweiten Ladezeit tc geladen werden kann, um eine zweite Lithiumschichtdicke an der Anode zu bilden;
   o Messen der Spannung Vc an den Anschlussklemmen der Vorrichtung;

wenn die Spannung Vc in einem in Abhängigkeit von der Architektur der Komponente definierten Intervall $Vc_{min}$-$Vc_{max}$ liegt, einen Rückhalteschritt (Ph-d), Folgendes umfassend:

   o Anlegen eines Stroms von null während einer Zeit td;
   o Messen der Spannung V an den Anschlussklemmen im zeitlichen Verlauf;
   o Bestimmen des Parameters Vd mit Vd = $\Delta V/\Delta t$;
   o wenn Vd in einem in Abhängigkeit von der Architektur der Komponente definierten Intervall $Vd_{min}$-$Vd_{max}$ liegt, ist die Vorrichtung als freigegeben getestet;

wobei das Testsystem Folgendes umfasst:
- einen Stromgenerator, der dafür konfiguriert ist, mit der Vorrichtung verbunden zu werden;
- einen Spannungsmesser, der dafür konfiguriert ist, mit der Vorrichtung verbunden zu werden;
- einen Kontroller, der an den Stromgenerator und den Spannungsmesser angeschlossen ist.

11. Testsystem nach Anspruch 10, wobei der Stromgenerator programmierbar ist und der Spannungsmesser programmierbar ist.

12. Testverfahren nach einem der Ansprüche 10 oder 11, wobei der Kontroller einen Zeitmesser, einen Speicher und einen Prozessor umfasst.

13. Satz einer Vielzahl von Testsystemen für eine Mikro-Energiespeichervorrichtung (Dn) nach nach einem der Ansprüche 10 bis 12, die das Verfahren nach einem der Ansprüche 1 bis 9 ausführen, wobei jedes System Folgendes umfasst:

   - einen Stromgenerator (An), der programmierbar sein kann und dafür konfiguriert ist, mit der Vorrichtung (Dn) verbunden zu werden;
   - einen Spannungsmesser (Vn), der programmierbar sein kann und dafür konfiguriert ist, mit der Vorrichtung (Dn) verbunden zu werden;
   - wobei jeder Stromgenerator (An) und jeder Spannungsmesser (Vn) an einem Kontroller (Cn) angeschlossen ist.

14. Testverfahren nach einem der Ansprüche 10 bis 12, wobei jeder Kontroller oder ein zentraler Kontroller einen Zeitmesser, einen Speicher und einen Prozessor umfasst.

15. Testsystem nach Anspruch 12 und Anspruch 14, umfassend einen zentralen Kontroller (Cc), der einen Speicher (Mc) aufweist, wobei jeder Kontroller (Cn) Testphasen für jedes Testsystem verwaltet, die Spannungsmessergebnisse in seinem Speicher (Mn) abspeichert, wobei der zentrale Kontroller die Messergebnisse erfasst, um sie in seinem Speicher (Mc) abzuspeichern.

**Claims**

1. A method for testing at least one energy micro-storage device comprising a anode made of metallic lithium formed by electrodeposition of Li⁺ ions on a metal inert to lithium ions, an electrolyte and a cathode, **characterized in that** said method comprises a sequence of testing steps during the manufacture of said anode, said sequence containing:

- a step of measuring (Ph-a) the initial voltage (OCV) of said device in open-circuit mode in order to obtain, at a time t0, the value of the initial voltage of said energy micro-storage device;
- if said initial voltage is non-zero, a first charging step (Ph-b) comprising:

    ○ applying a current Ib for a time tb in order to charge a first portion of said device for a minimum charging time so as to form a first lithium layer thickness at the anode;
    ○ measuring the voltage Vb across the terminals of said device;

determining the internal resistance Rb;
- if the voltage Vb is located within an interval $Vb_{min}$-$Vb_{max}$ defined on the basis of the architecture of the component and if the resistance Rb is located within an interval $Rb_{min}$-$Rb_{max}$ defined on the basis of the architecture of the component, a stabilization step (Ph-c) comprising:

    ○ continuing to apply at least one current Ic for a time tc in order to charge a second portion of said device for a second charging time tc so as to form a second lithium layer thickness at the anode;
    ○ measuring the voltage Vc across the terminals of said device;

- if the voltage Vc is located within an interval $Vc_{min}$-$Vc_{max}$ defined on the basis of the architecture of the component, a retention step (Ph-d) comprising:

    ○ applying a zero current for a time td;
    ○ measuring the voltage V across the terminals of the device over time;
    ○ determining the parameter Vd, where $Vd = \Delta V/\Delta t$;
    ○ if Vd is located within an interval $Vd_{min}$-$Vd_{max}$ defined on the basis of the architecture of the component, said device is tested as being valid.

2. The testing method according to claim 1, wherein:

    - the first charging step contains a series of measurements of voltages Vbi during periods $\Delta tbi$ spaced by times Tbi in order to determine the curve Vbi as a function of time and in order to determine the value of the voltage Vb which can be defined as the maximum value of the voltages Vbi or the average of the voltages Vbi;
    - the resistance Rb may be determined after each time tbi by the ratio Vbi/Ic of the curve Vbi as a function of time t.

3. The testing method according to claim 2, wherein the periods $\Delta tbi$ are of the order of 10 seconds, the times Tbi being of the order of 0.1 second.

4. The testing method according to one of claims 1 or 2, wherein the first thickness is of the order of a few nanometres and preferably 1 to 2 nanometres.

5. The testing method according to one of claims 2 to 4, wherein:

    - the stabilization step contains a series of measurements of voltages Vci during periods $\Delta tci$ spaced by times Tci in order to determine the value of the voltage Vc defined as the average of the voltages Vci.

6. The testing method according to claim 5, wherein the periods $\Delta tci$ are of the order of 50 seconds, the times Tci being of the order of 1 second.

7. The testing method according to one of claims 1 to 6, wherein the second thickness is less than 10 nanometres and preferably equal to 5 nanometres.

8. The testing method according to one of claims 1 to 7, wherein:

    - the retention step contains a series of measurements of voltages Vdi during periods $\Delta tdi$ spaced by times Tdi in order to determine the curve Vdi as a function of time;
    - the parameter Vd is determined by the gradient of the curve Vdi as a function of time t.

9. The testing method according to claim 8, wherein the periods $\Delta tdi$ are of the order of 10 seconds, the times Tdi being of the order of 1 second.

10. A system for testing at least one energy micro-storage device, implementing a method for testing at least one energy micro-storage device comprising an anode made of metallic lithium formed by electrodeposition of $Li^+$ ions on a metal inert to lithium ions, an electrolyte and a cathode, according to one of claims 1 to 9, said testing method comprising a sequence of testing steps during the manufacture of said anode, said sequence containing:

    - a step of measuring (Ph-a) the initial voltage (OCV) of said device in open-circuit mode in order to obtain, at a time t0, the value of the initial voltage of said energy micro-storage device;
    - if said initial voltage is non-zero, a first charging step (Ph-b) comprising:

o applying a current Ib for a time tb in order to charge a first portion of said device for a minimum charging time so as to form a first lithium layer thickness at the anode;
o measuring the voltage Vb across the terminals of said device;

determining the internal resistance Rb;
- if the voltage Vb is located within an interval $Vb_{min}$-$Vb_{max}$ defined on the basis of the architecture of the component and if the resistance Rb is located within an interval $Rb_{min}$-$Rb_{max}$ defined on the basis of the architecture of the component, a stabilization step (Ph-c) comprising:

o continuing to apply at least one current Ic for a time tc in order to charge a second portion of said device for a second charging time tc so as to form a second lithium layer thickness at the anode;
o measuring the voltage Vc across the terminals of said device;

- if the voltage Vc is located within an interval $Vc_{min}$-$Vc_{max}$ defined on the basis of the architecture of the component, a retention step (Ph-d) comprising:

o applying a zero current for a time td;
o measuring the voltage V across the terminals of the device over time;
o determining the parameter Vd, where Vd = $\Delta V/\Delta t$;
o if Vd is located within an interval $Vd_{min}$-$Vd_{max}$ defined on the basis of the architecture of the component, said device is tested as being valid;

said testing system comprising:

- a current generator configured to be connected to said device;
- a voltmeter configured to be connected to said device;
- a controller connected to said current generator and said voltmeter.

11. The testing system according to claim 10, wherein the current generator is programmable and the voltmeter is programmable.

12. The testing system according to one of claims 10 or 11, wherein the controller comprises a timer, a memory and a processor.

13. An assembly of a plurality of systems for testing an energy micro-storage device (Dn) according according to one of claims 10 to 12, implementing the method according to one of claims 1 to 9, each system comprising:

- a current generator (An), possibly programmable, and configured to be connected to said device (Dn);
- a voltmeter (Vn), possibly programmable, and configured to be connected to said device (Dn);
- each current generator (An) and each voltmeter (Vn) being connected to a controller (Cn).

14. The testing system according to one of claims 10 to 12, wherein each controller or a central controller comprises a timer, a memory and a processor.

15. The testing system according to claim 12 and claim 14, comprising a central controller (Cc) having a memory (Mc), each controller (Cn) managing the test phases for each testing system, recording the voltage measurement results in its memory (Mn), the central controller recovering said measurement results so as to record them in its memory (Mc).

[Fig. 1]

[Fig. 2]

[Fig. 3]

Phase Ph-a → Mesure de la tension OCV

= 0 ? → Oui → Arrêt du test

Non

Phase Ph-b → Forçage du courant Ir

Mesures et enregistrements des tensions avec Vn
Mesures et enregistrements des temps avec Crn ou Crc
A des temps prédéterminés
Calcul et enregistrement de la résistance Rb
Recherche et enregistrement de la tension Vb

Vbmin < Vb < Vbmax → Non → Arrêt du test

Oui

Rbmin < Rb < Rbmax → Non → Arrêt du test

Oui

Phase Ph-c → Mesures et enregistrements des tensions avec Vn
Mesures et enregistrements des temps avec Crn ou Crc
A des temps prédéterminés
Calcul et enregistrement de la tension moyenne Vc

Vcmin < Vc < Vcmax → Non → Arrêt du test

Oui

Phase Ph-d → Forçage du courant à 0.0

Mesures et enregistrements des tensions avec Vn
Mesures et enregistrements des temps avec Crn ou Crc
A des temps prédéterminés
Calcul et enregistrement de la pente Vd=ΔV / Δt

Vdmin < Vd < Vdmax → Non → Arrêt du test

Oui

Dispositif valide
Fin du test

[Fig. 4]

[Fig. 5]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 9209496 B
- US 6526361 B

**Littérature non-brevet citée dans la description**

- *J. Electrochem. Soc.*, 2000
- **XIAOYU LI et al.** *A comparative study of sorting methods for Lithium-ion batteries*
- **DE COLLINS JOHN et al.** *Fundamentals, impédance, and performance of solid-state LI-metal microbatteries*